(19) Europäisches Patentamt
European Patent Office
Office européen des brevets

(11) **EP 4 024 702 A1**

(12) **EUROPEAN PATENT APPLICATION**
published in accordance with Art. 153(4) EPC

(43) Date of publication:
**06.07.2022 Bulletin 2022/27**

(21) Application number: **20951920.6**

(22) Date of filing: **02.09.2020**

(51) International Patent Classification (IPC):
**H03B 5/12** *(2006.01)*

(52) Cooperative Patent Classification (CPC):
**H03B 5/12**

(86) International application number:
**PCT/CN2020/113056**

(87) International publication number:
**WO 2022/047673 (10.03.2022 Gazette 2022/10)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Shenzhen Goodix Technology Co., Ltd.
Shenzhen, Guangdong 518045 (CN)**

(72) Inventors:
• **YANG, Jiang**
  **Shenzhen, Guangdong 518045 (CN)**
• **HUA, Chao**
  **Shenzhen, Guangdong 518045 (CN)**
• **LING, Qiuchan**
  **Shenzhen, Guangdong 518045 (CN)**

(74) Representative: **Crugnola, Pietro et al
Luppi Intellectual Property Srl
Viale Corassori, 54
41124 Modena (IT)**

(54) **CAPACITOR ARRAY CIRCUIT, CHARGING AND DISCHARGING CIRCUIT, AND RC OSCILLATION CIRCUIT**

(57)     Disclosed in the present application is a capacitor array circuit, comprising N capacitors and N MOS transistors corresponding one to one to the N capacitors, a drain of each MOS transistor is connected to one end of a corresponding capacitor by means of a different metal line, a source of each MOS transistor is grounded, and a gate of each MOS transistor is used to receive a control signal to respectively control the on and off of each MOS transistor. The other ends of the N capacitors are connected to a common terminal. The capacitance value Cn-1 of an (n-1)th capacitor among the N capacitors is a times the capacitance value Cn of an nth capacitor. The sum of the on-resistance of an (n-1)th MOS transistor among the N MOS transistors and the resistance of a metal line between the (n-1)th capacitor and the (n-1)th MOS transistor is a times the sum of the on-resistance of an nth MOS transistor and the resistance of a metal line between the nth capacitor and the nth MOS transistor.

FIG. 4

**Description**

**TECHNICAL FIELD**

The present disclosure relates to the technical field of integrated circuits, and in particular, to a capacitor-array circuit, a charging-discharging circuit, and an RC oscillator circuit.

**BACKGROUND**

Electronic devices usually use oscillators to generate required clock signals. There are various types of oscillators, among which RC oscillators are widely applied due to advantages of low cost, low power consumption and adjustable frequency. However, an RC oscillator is sensitive to a parasitic parameter, which is related to the layout design, process and temperature of the RC oscillator. Therefore, an output frequency of the RC oscillator has a quite large deviation.

The RC oscillator usually uses a capacitor-array circuit to regulate the output frequency. However, the conventional capacitor-array circuit tends to ignore the effect of a parasitic resistance on a total capacitance of the capacitor-array circuit, causing the regulation of the output frequency of the RC oscillator by the capacitor-array circuit to be non-monotonic, thereby resulting in a large deviation in the output frequency of the RC oscillator.

**SUMMARY**

To overcome the problem in the prior art, the main objective of the present disclosure is to provide a capacitor-array circuit, a charging-discharging circuit, and an RC oscillator circuit that can regulate the output frequency of an RC oscillator monotonically, thereby improving the precision of the output frequency of the RC oscillator.

To achieve the above objective, the present disclosure adopts the following technical solutions. An embodiment of the present disclosure provides a capacitor-array circuit, including: N capacitors; and N MOS transistors corresponding to the N capacitors in a one-to-one manner. Each of the N MOS transistors includes a drain connected to a terminal of a corresponding capacitor of the N capacitors through at least one metal wire, a source connected to ground, and a gate configured to receive a control signal to control turn-on and turn-off of the MOS transistor. Another terminal of each of the N capacitors is connected to a common terminal, and the common terminal is used as a capacitance output terminal. A capacitance value of the (n-1)-th capacitor in the N capacitors is $C_{n-1}$, and a capacitance value of the n-th capacitor in the N capacitors is $C_n$, where $C_n = aC_{n-1}$. An on-resistance of the (n-1)-th MOS transistor in the N MOS transistors is $R_{onn-1}$, and an on-resistance of the n-th MOS transistor in the N MOS transistors is $R_{onn}$; a re-

sistance of the at least one metal wire between the (n-1)-th capacitor and the (n-1)-th MOS transistor is $R_{netn-1}$, and a resistance of the at least one metal wire between the n-th capacitor and the n-th MOS transistor is $R_{netn}$; and a sum of $R_{netn-1}$ and $R_{onn-1}$ is greater than or equal to $a$ times a sum of $R_{netn}$ and $R_{onn}$, a is greater than 1, N is an integer greater than or equal to 2, and n=[2, N].

In an embodiment, a width-to-length ratio of the (n-1)-th MOS transistor is $M_{n-1}$, a width-to-length ratio of the n-th MOS transistor is $M_n$, the width-to-length ratio $M_n$ of the n-th MOS transistor is b times the width-to-length ratio $M_{n-1}$ of the (n-1)-th MOS transistor, where b=a, the resistance $R_{netn-1}$ of the at least one metal wire between the (n-1)-th capacitor and the (n-1)-th MOS transistor is greater than or equal to $a$ times the resistance $R_{netn}$ of the at least one metal wire between the n-th capacitor and the n-th MOS transistor.

In an embodiment, a=b=2, the resistance $R_{netn-1}$ of the at least one metal wire between the (n-1)-th capacitor and the (n-1)-th MOS transistor is greater than or equal to 2 times the resistance $R_{netn}$ of the at least one metal wire between the n-th capacitor and the n-th MOS transistor.

In an embodiment, the at least one metal wire between the n-th capacitor and the n-th MOS transistor includes $a^{n-1}$ metal wires, where $a$ is an integer greater than 1; and each of the at least one metal wire has a same resistance value, and the at least one metal wire is connected in parallel between each capacitor and a corresponding MOS transistor.

In an embodiment, the at least one metal wire connected between the (n-1)-th capacitor and the (n-1)-th MOS transistor includes one metal wire and a resistance of the one metal wire is $R_{netn-1}$; the at least one metal wire connected between the n-th capacitor and the n-th MOS transistor includes one metal wire and a resistance of the one metal wire is $R_{netn}$; and the resistance $R_{netn-1}$ of the one metal wire between the (n-1)-th capacitor and the (n-1)-th MOS transistor is $a$ times the resistance $R_{netn}$ of the one metal wire between the n-th capacitor and the n-th MOS transistor.

In an embodiment, each of the at least one metal wire connected between each capacitor and a corresponding MOS transistor has a same resistance per square, and the number of squares of the at least one metal wire connected between the (n-1)-th capacitor and the (n-1)-th MOS transistor is $a$ times the number of the square of the at least one metal wire connected between the n-th capacitor and the n-th MOS transistor.

In an embodiment, the number of the at least one metal wire connected in series between the (n-1)-th capacitor and the (n-1)-th MOS transistor is $a$ times the number of the at least one metal wire connected in series between the n-th capacitor and the n-th MOS transistor, each of the at least one one metal wire connected between each capacitor and a corresponding MOS transistor has a same resistance per square, and a resistance per square of the at least one metal wire connected in series between the (n-1)-th capacitor and the (n-1)-th MOS transistor is the same as a resistance per square of the at least one metal wire connected in series between the n-th capacitor and the n-th MOS transistor.

In an embodiment, the number of the at least one metal wire connected in parallel between the n-th capacitor and the n-th MOS transistor is $a$ times the number of the at least one metal wire connected in parallel between the (n-1)-th capacitor and the (n-1)-th MOS transistor, each of the at least one metal wire connected between each capacitor and a corresponding MOS transistor has a same resistance per square, and a resistance per square of the at least one metal wire connected in series between the (n-1)-th capacitor and the (n-1)-th MOS transistor is the same as a resistance per square of the at least one metal wire connected in series between the n-th capacitor and the n-th MOS transistor.

In an embodiment, the at least one metal wire is at least one copper wire.

In an embodiment, the control signal is a pulse signal.

The present disclosure further provides a capacitor charging-discharging circuit, including the capacitor-array circuit described above, a power supply, a first electronic switch, a first resistor, and a second electronic switch. A first terminal of the first electronic switch is connected to the power supply; a second terminal of the first electronic switch is connected, through the resistor, to both the capacitance output terminal and a first terminal of the second electronic switch; a second terminal of the second electronic switch is connected to ground; each of a control terminal of the first electronic switch and a control terminal of the second electronic switch is configured to receive a clock signal; and each of the first electronic switch and the second electronic switch is turned on and turned off based on the clock signal.

In an embodiment, the first electronic switch is a PMOS transistor, and the second electronic switch is an NMOS transistor.

The present disclosure further provides an RC oscillator circuit, including a first charging-discharging circuit, a second charging-discharging circuit, a first comparator, a second comparator, a reference voltage unit, a logical unit, and a control unit. Each of the first charging-discharging circuit and the second charging-discharging circuit is the capacitor charging-discharging circuit described above; a first input terminal of the first comparator is connected to a capacitance output terminal of the first charging-discharging circuit, and a second input terminal of the first comparator is connected to the reference voltage unit; a first input terminal of the second comparator is connected to a capacitance output terminal of the second charging-discharging circuit, and a second input terminal of the second comparator is connected to the reference voltage unit; an output terminal of the first comparator and an output terminal of the second comparator are both connected to an input terminal of the logical unit, and an output terminal of the logical unit is connected to a control end of a first electronic switch and a control end of a second electronic switch; and the control unit is connected to a gate of each MOS transistor. The reference voltage unit is configured to generate a reference voltage; the first charging-discharging circuit is configured to transmit a first charging voltage or a first discharging voltage to the first comparator; the first comparator is configured to compare the first charging voltage with the reference voltage, or compare the first discharging voltage with the reference voltage, and output a first comparison result to the logical unit; the second charging-discharging circuit is configured to transmit a second charging voltage or a second discharging voltage to the second comparator; the second comparator is configured to compare the second charging voltage with the reference voltage, or compare the second discharging voltage with the reference voltage, and output a second comparison result to the logical unit; the logical unit is configured to output a clock signal based on the first comparison result and the second comparison result; the first charging-discharging circuit and the second charging-discharging circuit are configured to perform charging and discharging based on the clock signal; and the control unit is configured to control turn-on and turn-off of each MOS transistor through a control signal, to regulate a total capacitance of a capacitor-array circuit.

In an embodiment, the logical unit includes an RS trigger.

Compared with the prior art, the capacitor-array circuit, the charging-discharging circuit and the RC oscillator circuit of the present disclosure can cause the total capacitance outputted by the capacitor-array circuit to change monotonically, thereby improving the precision of the output frequency of the RC oscillator circuit.

## BRIEF DESCRIPTION OF DRAWINGS

FIG. 1 is a block diagram illustrating a principle of an RC oscillator circuit according to an embodiment of the present disclosure;

FIG. 2 is a block diagram illustrating a principle of an RC oscillator circuit according to another embodiment of the present disclosure;

FIG. 3 is a circuit diagram of a charging-discharging circuit according to an embodiment of the present disclosure;

FIG. 4 is a circuit diagram of a capacitor-array circuit according to an embodiment of the present disclosure;

FIG. 5 is a schematic diagram of connection between capacitors and MOS transistors according to an embodiment of the present disclosure;

FIG. 6 is a schematic diagram of connection between capacitors and MOS transistors according to another embodiment of the present disclosure;

FIG. 7 is a schematic diagram of connection between capacitors and MOS transistors according to still another embodiment of the present disclosure;

FIG. 8 is a schematic diagram of connection between capacitors and MOS transistors according to yet another embodiment of the present disclosure; and

FIG. 9 is a circuit diagram of an RC oscillator circuit according to an embodiment of the present disclosure.

## DETAILED DESCRIPTION

To make the objectives, technical solutions, and advantages of the present disclosure clearer, the present disclosure is further described in detail below with reference to the accompanying drawings and embodiments. It should be understood that the embodiments described herein are merely intended to explain the present disclosure, rather than to limit the present disclosure.

In the description of the present disclosure, unless otherwise specified and defined, the terms such as "first" and "second" are used only for the purpose of description and cannot be understood as indicating or implying relative importance; unless otherwise specified and defined, the term "multiple" means two or more; the terms "connected", "fixed" and the like should be comprehended in a broad sense. For example, a connection may be a fixed connection, a detachable connection, an integrated connection, or an electrical connection, and may be a direct connection, or an indirect connection through an intermediate medium. Those of ordinary skill in the art may understand specific meanings of the above terms in the present disclosure based on a specific situation.

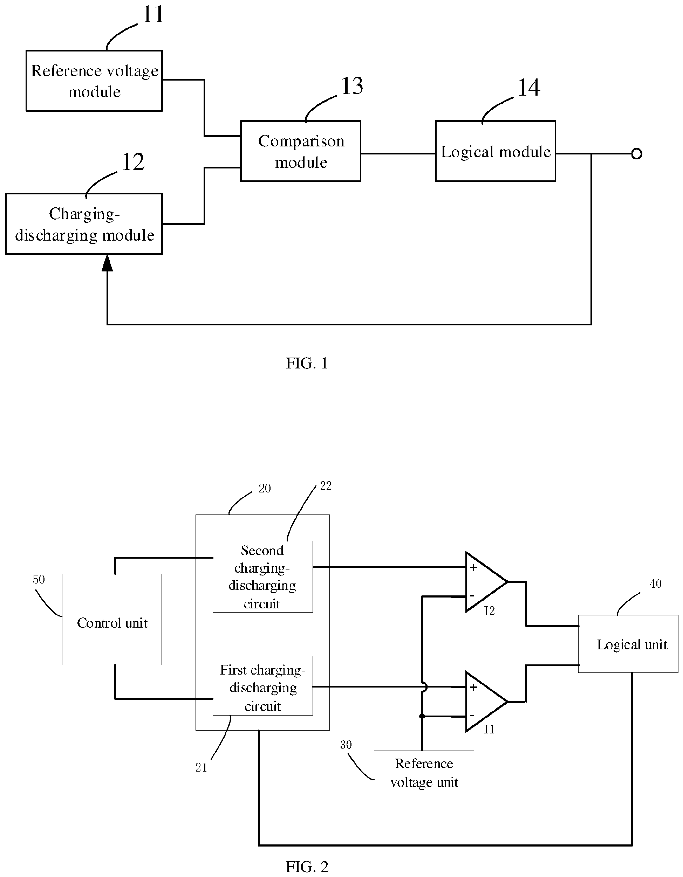

Referring to FIG. 1, a conventional RC oscillator circuit generally includes a reference voltage module 11, a charging-discharging module 12, a comparison module 13, and a logical module 14. An input terminal of the comparison module 13 is connected to the reference voltage module 11 and the charging-discharging module 12, an output terminal of the comparison module 13 is connected to an input terminal of the logical module 14, and an output terminal of the logical module 14 is connected to the charging-discharging module 12. The reference voltage module 11 is configured to generate a reference voltage. The charging-discharging module 12 is configured to transmit a charging-discharging voltage to the comparison module 13. The comparison module 13 is configured to compare the reference voltage with the charging-discharging voltage, and output a comparison result to the logical module 14. The logical module 14 is configured to output a clock signal according to the comparison result. The logical module 14 is further configured to feed back the clock signal to the charging-discharging module 12, and the charging-discharging module 12 is configured to perform charging and discharging according to the clock signal. The logical module 14 feeds back the clock signal to the charging-discharging module 12, so that the charging-discharging module 12 switches from a charging state to a discharging state or switches from a discharging state to a charging state. Hence, the charging-discharging module 12 performs charging and discharging cyclically, so that the RC oscillator circuit outputs the clock signal continuously.

The charging-discharging module 12 generally includes a capacitor-array circuit, and the RC oscillator circuit regulates a charging-discharging frequency of the charging-discharging module 12 by regulating a total capacitance of the capacitor-array circuit, thereby regulating the frequency of the clock signal outputted by the RC oscillator circuit. The total capacitance of the capacitor-array circuit is a sum capacitance of the capacitor-array circuit that is connected to the charging-discharging module 12 and participates in charging and discharging. The total capacitance of the capacitor-array circuit can be regulated through a switch. The regulation of the total capacitance of the conventional capacitor-array circuit tends to ignore the effect of the parasitic resistance on the total capacitance of the capacitor-array circuit connected to the charging-discharging module 12, causing the regulation on the frequency of the clock signal outputted by the RC oscillator circuit to be non-monotonic.

Referring to FIG. 2, an embodiment of the present disclosure provides an RC oscillator circuit, including a capacitor charging-discharging circuit 20, a first comparator I1, a second comparator 12, a reference voltage unit 30, a logical unit 40, and a control unit 50. The capacitor charging-discharging circuit 20 includes a first charging-discharging circuit 21 and a second charging-discharging circuit 22. A first input terminal of the first comparator I1 is connected to a capacitance output terminal of the first charging-discharging circuit 21, and a second input terminal of the first comparator I1 is connected to the reference voltage unit 30; a first input terminal of the second comparator 12 is connected to a capacitance output terminal of the second charging-discharging circuit 22, and a second input terminal of the second comparator 12 is connected to the reference voltage unit 30; an output terminal of the first comparator 11 and an output terminal of the second comparator 12 are both connected to an input terminal of the logical unit 40. An output terminal of the logical unit 40 is connected to an input terminal of the charging-discharging circuit 20. In an example, the output terminal of the logical unit 40 is connected to an input terminal of the first charging-discharging circuit 21 and an input terminal of the second charging-discharging circuit 22.

The reference voltage unit 30 is configured to generate a reference voltage. The first charging-discharging circuit 21 is configured to transmit a first charging voltage or a first discharging voltage to the first comparator I1. The clock signal includes a plurality of clock cycles, and each clock cycle includes a first half cycle and a second half cycle. The first charging voltage is a voltage outputted by the first charging-discharging circuit 21 in the first half cycle of each clock cycle, and the first discharging voltage is a voltage outputted by the first charging-discharging circuit 21 in the second half cycle of each clock cycle. The first comparator 11 is configured to compare the first charging voltage with the reference voltage or compare the first discharging voltage with the reference voltage, and output a first comparison result to the logical unit 40. The second charging-discharging circuit 22 is configured to transmit a second charging voltage or a second discharging voltage to the second comparator 12. The second discharging voltage is a voltage outputted by the second charging-discharging circuit 22 in the first half cycle of each clock cycle, and the second charging voltage is a voltage outputted by the second charging-discharging circuit 22 in the second half cycle of each clock cycle. The second comparator 12 is configured to compare the second charging voltage with the reference voltage or compare the second discharging voltage with the reference voltage, and output a second comparison result to the logical unit 40. The logical unit 40 is configured to output a clock signal according to the first comparison result and the second comparison result. The logical unit 40 is further configured to feed back the clock signal to the first charging-discharging circuit 21 and the second charging-discharging circuit 22; the first charging-discharging circuit 21 and the second charging-discharging circuit 22 perform charging and discharging according to the clock signal. The logical unit 40 feeds back the clock signal to the charging-discharging module 12, so that the first charging-discharging circuit 21 and the second charging-discharging circuit 22 switch from a charging state to a discharging state or switch from a discharging state to a charging state. Hence, the first charging-discharging circuit 21 and the second charging-discharging circuit 22 perform charging and discharging cyclically, so that the RC oscillator circuit outputs the clock signal continuously.

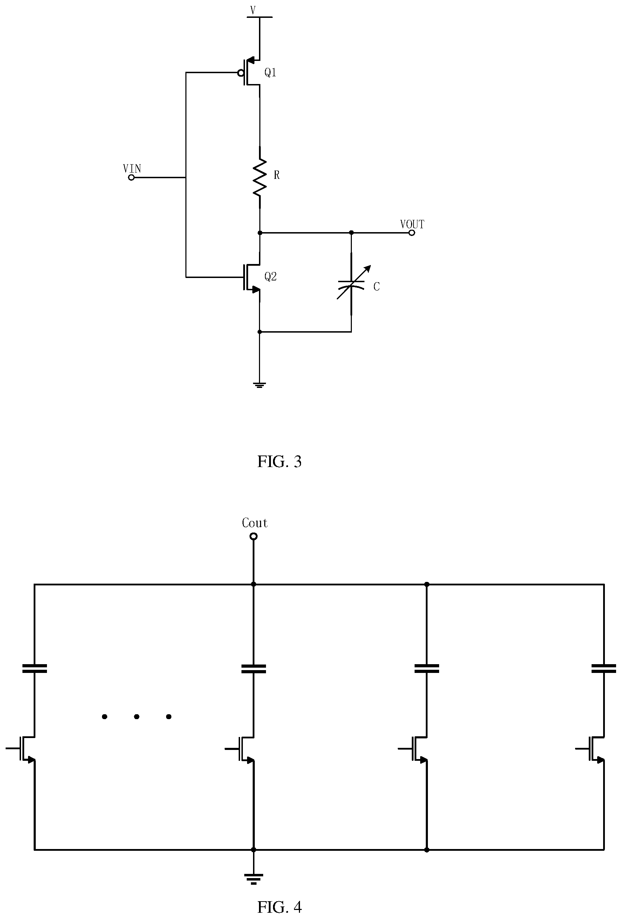

Referring to FIG. 3, in an example, the charging-discharging circuit 20 (e.g., the charging-discharging module 12 shown in FIG. 1 or the first charging-discharging circuit 21 and the second charging-discharging circuit 22 shown in FIG. 2) includes a capacitor-array circuit C, a power supply V, a first electronic switch Q1, a first resistor R, and a second electronic switch Q2.

The clock signal includes a plurality of clock cycles, and each clock cycle includes a first half cycle and a second half cycle. In the first half cycle of each clock cycle, an input at the input terminal VIN is a high level, the first electronic switch Q1 is turned off, the second electronic switch Q2 is turned on, and the charging-discharging circuit 20 performs discharging. In the second half cycle of each clock cycle, an input at the input terminal VIN is a low level, the first electronic switch Q1 is turned on, the second electronic switch Q2 is turned off, and the charging-discharging circuit 20 performs charging. The level inputted at the input terminal VIN changes cyclically according to the clock cycle, so that the charging-discharging circuit 20 performs charging and discharging alternately.

Referring to FIG. 4, in an example, the capacitor-array circuit C (e.g., the capacitor-array circuit C shown in FIG. 3) includes N capacitors and N MOS transistors. The N MOS transistors correspond to the N capacitors in a one-to-one manner, where a drain of each MOS transistor among the N MOS transistors is connected to one terminal of a corresponding capacitor through a different metal wire, a source of each MOS transistor is connected to ground, and a gate of each MOS transistor is used for receiving a control signal to control turn-on and turn-off of each MOS transistor. Another terminal of each of the N capacitors is connected to a common terminal, and the common terminal is used as a capacitance output terminal Cout of the capacitor-array circuit C. Each MOS transistor among the N MOS transistors and the corresponding capacitor form a capacitance branch. For example, a first MOS transistor among the N MOS transistors and a first capacitor form a first capacitance branch, a second MOS transistor and a second capacitor form a second capacitance branch, an N-th MOS transistor and an N-th capacitor form an N-th capacitance branch, and so on. That is, the n-th MOS transistor and the n-th capacitor form the n-th capacitance branch. Each MOS transistor is turned on or turned off under the control of the control signal, so as to control whether the capacitance branch in which the MOS transistor is located joins the capacitor-array circuit C. In an example, when the n-th MOS transistor is turned on under the control of the control signal, the n-th capacitance branch formed by the n-th MOS transistor and the n-th capacitor is connected in parallel with other capacitance branches, that is, the n-th capacitance branch joins the capacitor-array circuit C. N is an integer greater than or equal to 2.

A capacitance value of the first capacitor is C1, a capacitance value of the second capacitor is C2, a capacitance value of the third capacitor is C3..., a capacitance value of the (n-1)-th capacitor is Cn-1, and a capacitance value of the n-th capacitor is Cn.

An on-resistance of the first MOS transistor is $R_{on1}$, an on-resistance of the second MOS transistor is $R_{on2}$, an on-resistance of the third MOS transistor is $R_{on3}$..., an on-resistance of the (n-1)-th MOS transistor is $R_{onn-1}$, and an on-resistance of the n-th MOS transistor is $R_{onn}$.

A resistance of a metal wire between the first capacitor and the first MOS transistor is $R_{net1}$, a resistance of a metal wire between the second capacitor and the second MOS transistor is $R_{net2}$, a resistance of a metal wire between the third capacitor and the third MOS transistor is $R_{net3}$..., a resistance of a metal wire between the (n-1)-th capacitor and the (n-1)-th MOS transistor is $R_{netn-1}$, and a resistance of a metal wire between the n-th capacitor and the n-th MOS transistor is $R_{netn}$.

The conventional RC oscillator circuit tends to ignore the on-resistances of the N MOS transistors and the resistances of the metal wires between the capacitors and the MOS transistors. That is, the on-resistances of the N MOS transistors and the resistances of the metal wires between the capacitors and the MOS transistors are regarded as 0 ohms. However, each MOS transistor has a certain on-resistance when being turned on, and the metal wires between the capacitors and the MOS transistors also have certain resistances. The parasitic resistance of the RC oscillator circuit includes the on-resistance of each MOS transistor and the resistance of the metal wire between each capacitor and the corresponding MOS transistor. The on-resistance of each MOS transistor and the resistance of the metal wire between each capacitor and the corresponding MOS transistor affect the monotonicity of the regulation on the total capacitance of the capacitor-array circuit C, thereby affecting the monotonicity of the regulation on the frequency of the clock signal outputted by the RC oscillator circuit, resulting in a large error in the frequency of the clock signal outputted by the RC oscillator circuit.

Considering the impact of the parasitic resistance on the total capacitance of the capacitor-array circuit C, when the MOS transistors of the N capacitor branches are all turned on, equivalent capacitances C1', C2', C3',..., Cn' of the N capacitor branches are:

$$C1' = \frac{C1}{1 + 2\pi * f * C1 * (R_{net1} + R_{on1})}$$

$$C2' = \frac{C2}{1 + 2\pi * f * C2 * (R_{net2} + R_{on2})}$$

$$C3' = \frac{C3}{1 + 2\pi * f * C3 * (R_{net3} + R_{on3})}$$

...

$$Cn' = \frac{Cn}{1 + 2\pi * f * Cn * (R_{netn} + R_{onn})}$$

where f is half of the frequency of the clock signal. The capacitance values of the N capacitors in the capacitor-array circuit C are generally configured according to a certain ratio. When $C2 = aC1$, $C3 = aC2$, $C4 = aC3$,..., $Cn - 1 = aCn - 2$, and $Cn = aCn-1$, i.e., $C1:C2:C3:C4:...:Cn-1:Cn=a^0:a^1:a^2:a^3:a^4:...:a^{n-2}:a^{n-1}$, $C2' \geq aC1'$, $C3' \geq aC2'$, $C4' \geq aC3'$..., $C(n - 1)' \geq aC(n - 2)'$, and $Cn' \geq aC(n - 1)'$, in other words, when considering the impact of the parasitic resistance on the total capacitance of the capacitor-array circuit C, the equivalent capacitances C1', C2', C3',... Cn' of the N capacitor branches meet the following relationships: $C2' \geq aC1'$, $C3' \geq aC2'$, $C4' \geq aC3'$..., $C(n - 1)' \geq aC(n - 2)'$, and $Cn' \geq aC(n - 1)'$, the total capacitance outputted by the capacitor-array circuit C changes monotonically, where a is greater than 1.

When $C2' \geq aC1'$, $C3' \geq aC2'$, $C4' \geq aC3'$..., $C(n - 1)' \geq aC(n - 2)'$, and $Cn' \geq aC(n - 1)'$, then $R_{net1} + R_{on1} - a * (R_{net2} + R_{on2})$, $R_{net2} + R_{on2} \geq a * (R_{net3} + R_{on3})$, $R_{net3} + R_{on3} \geq a * (R_{net4} + R_{on4})$ ..., and $R_{netn-1} + R_{onn-1} \geq a * (R_{netn} + R_{onn})$.

In one embodiment, if the impact of the on-resistance of each MOS transistor among the N MOS transistors on the total capacitance of the capacitor-array circuit C is taken into consideration while the impact of the resistance of the metal wire between each capacitor in the N capacitors and the corresponding MOS transistor on the total capacitance of the capacitor-array circuit C is ignored, i.e., a value each of of $R_{net1}$, $R_{net2}$, Rnet3..., $R_{netn-1}$, and $R_{netn}$ is regarded as 0, then $R_{on1} \geq aR_{on2}$, $R_{on2} \geq aR_{on3}$, $R_{on3} \geq aR_{on4}$..., and $R_{onn-1} \geq aR_{onn}$. That is, the capacitance value Cn of the n-th capacitor is a times the capacitance value Cn-1 of the (n-1)-th capacitor, and the on-resistance $R_{onn-1}$ of the (n-1)-th MOS transistor is greater than or equal to a times the on-resistance Ronn of the n-th MOS transistor, so as to improve the monotonicity of the regulation on the total capacitance of the capacitor-array circuit C, where n=[2, N].

In one embodiment, if the impact of the resistance of the metal wire between each capacitor in the N capacitors and the corresponding MOS transistor on the total capacitance of the capacitor-array circuit C is taken into consideration while the impact of the on-resistance of each MOS transistor in the N MOS transistors on the total capacitance of the capacitor-array circuit C is ignored, i.e., a value of each of $R_{on1}$, $R_{on2}$, Ron3..., $R_{onn-1}$, and Ronn is regarded as 0, then $R_{net1} \geq aR_{net2}$, $R_{net2} \geq aR_{net3}$, $R_{net3} \geq aR_{net4}$..., and $R_{netn-1} \geq aR_{netn}$. That is, the capacitance value Cn of the n-th capacitor is a times the capacitance value Cn-1 of the (n-1)-th capacitor, and the metal resistance $R_{netn-1}$ between the (n-1)-th capacitor and the (n-1)-th MOS transistor is greater than or equal to a times the resistance $R_{netn}$ of the metal wire between the n-th capacitor and the n-th MOS transistor, so as to improve the monotonicity of the regulation on the total capacitance of the capacitor-array circuit C, where n=[2, N].

In one embodiment, if the impact of the resistance of the metal wire between each capacitor in the N capacitors and the corresponding MOS transistor and the impact of the on-resistance of each MOS transistor in the N MOS transistors on the total capacitance of the capacitor-array circuit C are both taken into consideration, i.e., a value of each of $R_{net1}$, Rnet2, Rnet3..., $R_{netn-1}$, and $R_{netn}$ and values of $R_{on1}$, $R_{on2}$, Ron3..., $R_{onn-1}$, and Ronn is not regarded as 0, then $R_{net1} + R_{on1} \geq a * (R_{net2} + R_{on2})$, $R_{net2} + R_{on2} \geq a * (R_{net3} + R_{on3})$, $R_{net3} + R_{on3} \geq a * (R_{net4} + R_{on4})$..., and $R_{netn-1} + R_{onn-1} \geq a * (R_{netn} + R_{onn})$. That is, the capacitance value Cn of the n-th capacitor is a times the capacitance value Cn-1 of the (n-1)-th capacitor, and a sum of the resistance $R_{netn-1}$ of the metal wire between the capacitor and the MOS transistor in the (n-1)-th capacitance branch and the on-resistance $R_{onn-1}$ of the MOS transistor is greater than or equal to a times a sum of the resistance $R_{netn}$ of the metal wire between the capacitor and the MOS transistor in the n-th capacitance branch and the on-resistance Ronn of the MOS transistor, so as to improve the monotonicity of the regulation on the total capacitance of the capacitor-array circuit C, where n=[2, N].

The on-resistance of the MOS transistor is inversely proportional to a width-to-length ratio of the MOS transistor. For example, if the width-to-length ratio of the MOS transistor is doubled, the on-resistance of the MOS transistor is reduced by half. The width-to-length ratio of the first MOS transistor is M1, the width-to-length ratio of the second MOS transistor is M2, the width-to-length ratio of the third MOS transistor is M3..., the width-to-length ratio of the (n-1)-th MOS transistor is Mn-1, and the width-to-length ratio of the n-th MOS transistor is Mn. The width-to-length ratio of the MOS transistor is a ratio of a width of a conductive channel of the MOS transistor to a length of a conductive channel of the MOS transistor.

When $M1:M2:M3:...:Mn-1:Mn=b^0:b^1:b^2:...:b^{n-2}:b^{n-1}$, i.e., M2=bM1, M3=bM2, M4=bM3,..., Mn-1=bMn-2, Mn=bMn-1, $R_{on1}:R_{on2}:R_{on3}:...:R_{onn-1}:R_{onn}=b^{n-1}:b^{n-2}:...:b^2:b^1:b^0$. That is, when the width-to-length ratio Mn of the n-th MOS transistor is b times the width-to-length ratio Mn-1 of the (n-1)-th MOS transistor, the on-resistance Ronn of the n-th MOS transistor is 1/b of the on-resistance $R_{onn-1}$ of the (n-1)-th MOS transistor.

Further, when b=a, it can be obtained from $R_{net1} + R_{on1} \geq a * (R_{net2} + R_{on2})$, $R_{net2} + R_{on2} \geq a * (R_{net3} + R_{on3})$, $R_{net3} + R_{on3} \geq a * (R_{net4} + R_{on4})$ ..., and $R_{netn-1} + R_{onn-1} \geq a * (R_{netn} + R_{onn})$ that:

$R_{net1} \geq a * R_{net2}$ $R_{net2} \geq a * R_{net3}$, $R_{net3} \geq a * R_{net4}$ ..., and $R_{netn-1} \geq a * R_{netn}$, that is, $R_{net1} \geq a * R_{net2} \geq a^2 * R_{net3} \geq ... \geq a^{n-1} * R_{netn}$. That is, the resistance $R_{netn-1}$ of the metal wire between the (n-1)-th capacitor and the (n-1)-th MOS transistor is greater than or equal to a times the resistance $R_{netn}$ of the metal wire between the n-th capacitor and the n-th MOS transistor.

When the ratio among the capacitance value of the first capacitor to the capacitance value of the n-th capacitor in the N capacitors is the same as the ratio among the width-to-length ratio of the first MOS transistor to the width-to-length ratio of the n-th MOS transistor in the N MOS transistors, the resistance $R_{netn-1}$ of the metal wire between the (n-1)-th capacitor and the (n-1)-th MOS transistor is greater than or equal to a times the resistance $R_{netn}$ of the metal wire between the n-th capacitor and the n-th MOS transistor, so that the regulation on the total capacitance of the capacitor-array circuit C is monotonic.

The control unit 50 is provided with binary signals trim<1>, trim<2>, trim<3>,..., trim<n-1>, and trim<n> that correspond to the N MOS transistors respectively. When values corresponding to trim<1>, trim<2>, trim<3>,..., trim<n-1>, and trim<n> change monotonically, the total capacitance outputted by the capacitor-array circuit C is monotonic, and the frequency of the clock signal outputted by the RC oscillator circuit changes monotonically. For example, when the values corresponding to trim<1>, trim<2>, trim<3>,..., trim<n-1>, and trim<n> increase progressively, the total capacitance outputted by the capacitor-array circuit C increases progressively, and the frequency of the clock signal outputted by the RC oscillator circuit decreases progressively. The control unit 50 further converts the binary signals trim<1>, trim<2>, trim<3>,..., trim<n-1>, and trim<n> into pulse signals respectively, and transmits each pulse signal to a corresponding MOS transistor, so that the MOS transistor is turned on or turned off under the control of the pulse signal.

When a=b=2, C2=2C1, C3=2C2,..., Cn-1=2Cn-2, and Cn=2Cn-1, that is, $C1:C2:C3:C4:...:Cn-1:Cn=2^0:2^1:2^2:2^3:2^4:...:2^{n-2}:2^{n-1}$, $C2' \geq 2C1'$, $C3' \geq 2C2'$, $C4' \geq 2C3'$ ..., and $C(n-1)' \geq 2C(n-2)'$, $Cn' \geq 2C(n-1)'$, then $R_{net1} + R_{on1} \geq 2 * (R_{net2} + R_{on2})$, $R_{net2} + R_{on2} \geq 2 * (R_{net3} + R_{on3})$, $R_{net3} + R_{on3} \geq 2 * (R_{net4} + R_{on4})$, ..., and $R_{netn-1} + R_{onn-1} \geq 2 * (R_{netn} + R_{onn})$. That is, the sum of the resistance $R_{netn-1}$ of the metal wire between the capacitor and the MOS transistor in the (n-1)-th capacitance branch and the on-resistance $R_{onn-1}$ of the MOS transistor is greater than or equal to 2 times the sum of the resistance $R_{netn}$ of the metal wire between the capacitor and the MOS transistor in the n-th capacitance branch and the on-resistance Ronn of the MOS transistor.

When $M1:M2:M3:...:Mn-1:Mn==2^0:2^1:2^2:...:2^{n-2}:2^{n-1}$, $R_{on1}:R_{on2}:R_{on3}:...:R_{onn-1}:R_{onn}=2^{n-1}:2^{n-2}:...:2^2:2^1:2^0$, that is, when the width-to-length ratio Mn of the n-th MOS transistor is 2 times the width-to-length ratio Mn-1 of the (n-1)-th MOS transistor, the on-resistance $R_{onn}$ of the n-th MOS transistor is 1/2 of the on-resistance $R_{onn-1}$ of the (n-1)-th MOS transistor. In this case, $R_{net1} \geq 2 * R_{net2}$, $R_{net2} \geq 2 * R_{net3}$, $R_{net3} \geq 2 * R_{net4}$ ..., and $R_{netn-1} \geq 2 * R_{netn}$, that is, $R_{net1} \geq 2 * R_{net2} \geq 2^2 * R_{net3} \geq ... \geq 2^{n-1} * R_{netn}$. In other words, the resistance $R_{netn-1}$ of the metal wire between the (n-1)-th capacitor and the (n-1)-th MOS transistor is greater than or equal to 2 times the resistance $R_{netn}$ of the metal wire between the n-th capacitor and the n-th MOS transistor.

When the values corresponding to the binary control signals trim<1>, trim<2>, trim<3>,..., trim<n-1>, and trim<n> which are configured by the control unit 50 for the first MOS transistor to the n-th MOS transistor in the N MOS transistors change monotonically, the frequency of the clock signal outputted by the RC oscillator circuit changes monotonically, and the frequency of the clock signal outputted by the RC oscillator circuit changes at equal steps.

When a=b=2, a step of regulation of the total capacitance of the capacitor-array circuit C may be an integer multiple of C1, and the minimum step of regulation of the total capacitance of the capacitor-array circuit C is C1.

In an embodiment, there is one metal wire between the first capacitor and the first MOS transistor, there are a metal wires between the second capacitor and the second MOS transistor, there are $a^2$ metal wires

between the third capacitor and the third MOS transistor..., there are $a^{n-2}$ metal wires between the (n-1)-th capacitor and the (n-1)-th MOS transistor, and there are $a^{n-1}$ metal wires between the n-th capacitor and the n-th MOS transistor. Each metal wire has the same resistance value, and the metal wires are connected in parallel between each capacitor and a corresponding MOS transistor, where $a$ is an integer greater than 1.

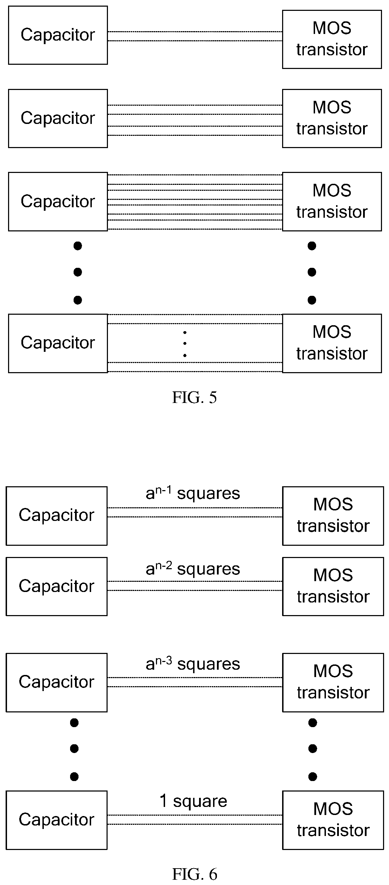

Referring to FIG. 5, when a=2, there is one metal wire between the first capacitor and the first MOS transistor, there are 2 metal wires between the second capacitor and the second MOS transistor, there are 4 metal wires between the third capacitor and the third MOS transistor..., there are $2^{n-2}$ metal wires between the (n-1)-th capacitor and the (n-1)-th MOS transistor, and there are $2^{n-1}$ metal wires between the n-th capacitor and the n-th MOS transistor.

By providing $a^{n-1}$ parallel metal wires having the same resistance value between the n-th capacitor and the n-th MOS transistor, monotonic regulation on the total capacitance of the capacitor-array circuit C can be implemented without an additional resistor, thus achieving low costs.

In an embodiment, there is one metal wire between the first capacitor and the first MOS transistor and the resistance of the metal wire is $R_{net1}$, there is one metal wire between the second capacitor and the second MOS transistor and the resistance of the metal wire is $R_{net2}$, there is one metal wire between the third capacitor and the third MOS transistor and the resistance of the metal wire is $R_{net3}$..., there is one metal wire between the (n-1)-th capacitor and the (n-1)-th MOS transistor and the resistance of the metal wire is $R_{netn-1}$, and there is one metal wire between the n-th capacitor and the n-th MOS transistor and the resistance of the metal wire is $R_{netn}$, where $R_{net1}:R_{net2}:R_{net3}:...:R_{netn-2}:R_{netn-1}:R_{netn}=a^{n-1}:a^{n-2}:a^{n-3}:...:a^2:a^1:a^0$. When a=2, $R_{net1}:R_{net2}:R_{net3}:...:R_{netn-2}:R_{netn-1}:R_{netn}=2^{n-1}:2^{n-2}:2^{n-3}:...:2^2:2^1:2^0$.

In this embodiment, only one metal wire is provided between each capacitor and a corresponding MOS transistor, thereby reducing the area occupied by the metal wires, and the wiring operation is simpler.

In a process of manufacturing an integrated circuit, a resistance of a metal wire is generally defined as R=PL/W, where P is a resistance per square, L is a length of the metal wire, W is a width of the metal wire, and L/W is the number of squares.

Referring to FIG. 6, when $R_{net1} = a * R_{net2} = a^2 * R_{net3} =...= a^{n-1} * R_{netn}$, if each capacitor and a corresponding MOS transistor are connected by using metal wires having the same resistance per square, the number of squares of metal wires between the first capacitor and the first MOS transistor is $a^{n-1}$, the number of squares of metal wires between the second capacitor and the second MOS transistor is $a^{n-2}$, the number of squares of metal wires between the third capacitor and the third

MOS transistor is $a^{n-3}$..., the number of squares of metal wires between the (n-1)-th capacitor and the (n-1)-th MOS transistor is a, and the number of squares of metal wires between the n-th capacitor and the n-th MOS transistor is 1. That is, the number of squares of metal wires between the (n-1)-th capacitor and the (n-1)-th MOS transistor is $a$ times the number of squares of metal wires between the n-th capacitor and the n-th MOS transistor.

In an example, $a^{n-1}$ metal wires are connected in series between the first capacitor and the first MOS transistor and the $a^{n-1}$ metal wires have the same resistance per square; $a^{n-2}$ metal wires are connected in series between the second capacitor and the second MOS transistor and the $a^{n-2}$ metal wires have the same resistance per square; $a^{n-3}$ metal wires are connected in series between the third capacitor and the third MOS transistor and the $a^{n-3}$ metal wires have same resistance per square,...; a metal wires are connected in series between the (n-1)-th capacitor and the (n-1)-th MOS transistor and the $a$ metal wires have the same resistance per square; one metal wire is connected between the n-th capacitor and the n-th MOS transistor. That is, the number of metal wires connected in series between the (n-1)-th capacitor and the (n-1)-th MOS transistor is $a$ times the number of metal wires connected in series between the n-th capacitor and the n-th MOS transistor, each metal wire connected between each capacitor and a corresponding MOS transistor has the same resistance per square, the resistance per square of the metal wires connected in series between the (n-1)-th capacitor and the (n-1)-th MOS transistor is the same as the resistance per square of the metal wires connected in series between the n-th capacitor and the n-th MOS transistor. That is, the resistance per square of the metal wire in each capacitance branch is the same as the resistance per square of the metal wire in each of other capacitance branches. The metal wires connected in series in each capacitance branch may be arranged in a same layer of the circuit board, where $a$ is an integer greater than 1.

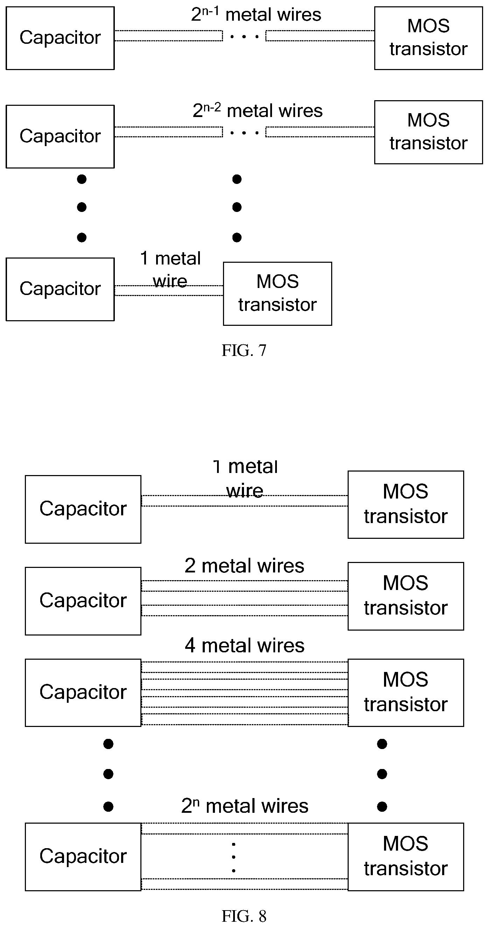

Referring to FIG. 7, when a=2, $2^{n-1}$ metal wires are connected in series between the first capacitor and the first MOS transistor and the $2^{n-1}$ metal wires have the same resistance per square; $2^{n-2}$ metal wires are connected in series between the second capacitor and the second MOS transistor and the $2^{n-2}$ metal wires have the same resistance per square; $2^{n-3}$ metal wires are connected in series between the third capacitor and the third MOS transistor and the $2^{n-3}$ metal wires have same resistance per square,...; 2 metal wires are connected in series between the (n-1)-th capacitor and the (n-1)-th MOS transistor and the 2 metal wires have the same resistance per square; one metal wire is connected between the n-th capacitor and the n-th MOS transistor. The resistance per square of the metal wire in each capacitance branch is the same as the resistance per squares of the metal wire in each of other capacitance branches. The metal wires connected in series in each capacitance branch may be arranged in a same layer of the circuit board.

In an example, one metal wire is connected between the first capacitor and the first MOS transistor; $a$ metal wires are connected in parallel between the second capacitor and the second MOS transistor and the $a$ metal wires have a same resistance per square; $a^2$ metal wires are connected in parallel between the third capacitor and the third MOS transistor and the $a^2$ metal wires have a same resistance per square,...; $a^{n-2}$ metal wires are connected in parallel between the (n-1)-th capacitor and the (n-1)-th MOS transistor and the $a^{n-2}$ metal wires have a same resistance per square; $a^{n-1}$ metal wires are connected in parallel between the n-th capacitor and the n-th MOS transistor and the $a^{n-1}$ metal wires have a same resistance per square. That is, the number of metal wires connected in parallel between the n-th capacitor and the n-th MOS transistor is $a$ times the number of metal wires connected in parallel between the (n-1)-th capacitor and the (n-1)-th MOS transistor, the metal wires connected between each capacitor and a corresponding MOS transistor have the same resistance per square, the resistance per square of the metal wires connected in series between the (n-1)-th capacitor and the (n-1)-th MOS transistor is the same as the resistance per square of the metal wires connected in series between the n-th capacitor and the n-th MOS transistor. That is, the resistance per square of the metal wire in each capacitance branch is the same as the resistance per square of the metal wire in each of other capacitance branches. The metal wires connected in parallel in each capacitance branch may be arranged in different layers of the circuit board, where $a$ is an integer greater than 1.

Referring to FIG. 8, when a=2, one metal wire is connected between the first capacitor and the first MOS transistor; 2 metal wires are connected in parallel between the second capacitor and the second MOS transistor and the 2 metal wires have the same resistance per square; 4 metal wires are connected in parallel between the third capacitor and the third MOS transistor and the 4 metal wires have same resistance per square,...; $2^{n-2}$ metal wires are connected in parallel between the (n-1)-th capacitor and the (n-1)-th MOS transistor and the $2^{n-2}$ metal wires have the same resistance per square; $2^{n-1}$ metal wires are connected in parallel between the n-th capacitor and the n-th MOS transistor and the $2^{n-1}$ metal wires have the same resistance per square. The resistance per square of the metal wire in each capacitance branch is the same as the resistance per square of the metal wire in each of other capacitance branches. The metal wires connected in parallel in each capacitance branch may be arranged in different layers of the circuit board.

One or more layers of metal wires connected in series or in parallel may be provided between the capacitor and the MOS transistor in each capacitance branch, so that the resistance of the metal wires between the capacitors and the MOS transistors in multiple capacitance branches of the capacitor-array circuit change monotonically.

Referring to FIG. 3, a first terminal of the first electronic switch Q1 is connected to the power supply V, and a second terminal of the first electronic switch Q1 is connected to a first terminal of the second electronic switch Q2 and the capacitance output terminal through the resistor R; a second terminal of the second electronic switch Q2 is connected to ground; a control terminal of the first electronic switch Q1 and a control terminal of the second electronic switch Q2 are each used for receiving a clock signal; the first electronic switch Q1 and the second electronic switch Q2 are turned on and turned off based on the clock signal. An output terminal of the logical unit 40 is connected to the control terminal of the first electronic switch Q1 and the control terminal of the second electronic switch Q2. In the figure, the control terminal of the first electronic switch Q1, the control terminal of the second electronic switch Q2, and the output terminal of the logical unit 40 are connected to the VIN terminal, here, the VOUT terminal is the capacitance output terminal.

A total capacitance outputted by the capacitor-array circuit C changes monotonically, so that the charging-discharging frequency of the capacitor charging-discharging circuit 20 changes monotonically.

In an embodiment, the first electronic switch Q1 is a PMOS transistor; and the first terminal, the second terminal, and the third terminal of the first electronic switch Q1 correspond to a drain, a source, and a gate of the PMOS transistor, respectively. The second electronic switch Q2 is an NMOS transistor; and the first terminal, the second terminal, and the third terminal of the second electronic switch Q2 correspond to a drain, a source, and a gate of the NMOS transistor, respectively.

The control unit 50 is connected to the gate of each MOS transistor. The control unit 50 is configured to control turn-on and turn-off of each MOS transistor through the control signal, to regulate the total capacitance of the capacitor-array circuit C.

The control unit 50 is configured to control turn-on and turn-off of each MOS transistor through the control signal, to regulate the total capacitance of the capacitor-array circuit C. The control signal is a pulse signal. In an example, the control unit 50 sets the binary signals for the first MOS transistor to the n-th MOS transistor as follows: trim<1>, trim<2>, trim<3>,..., trim<n-1>, and trim<n> respectively, and transmits a pulse signal corresponding to each binary signal to the corresponding MOS transistor. When values corresponding to the binary signals trim<1>, trim<2>, trim<3>,..., trim<n-1>, and trim<n> change monotonically, the charging-discharging frequency of the charging-discharging circuit 20 changes monotonically, so that the frequency of the clock signal outputted by the RC oscillator circuit changes monotonically, thereby improving the precision of the output frequency of the RC oscillator.

The control unit 50 regulates the total capacitance of the capacitor-array circuit C to change monotonically, so that the charging-discharging frequency of the charging-discharging circuit 20 changes monotonically, and the frequency of the clock signal outputted by the RC oscillator circuit changes monotonically, thereby improving the precision of the output frequency of the RC oscillator.

The logical unit 40 may include an RS trigger and an inverter. The metal wire may be a copper wire, which has good conductivity and low cost.

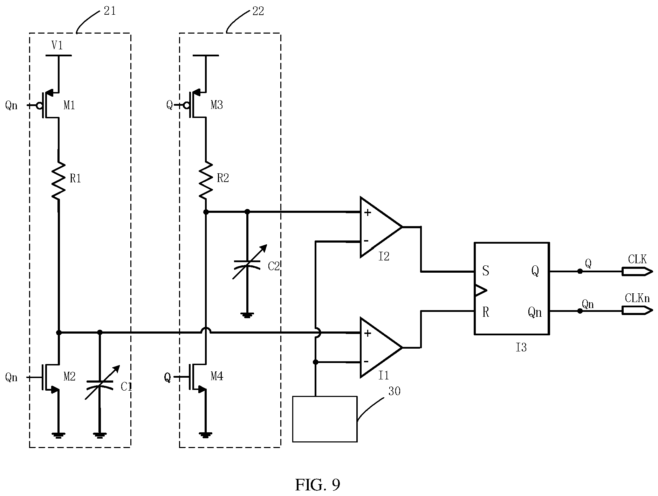

The working principle of the RC oscillator circuit in the embodiments of the present disclosure is described below by using the circuit diagram shown in FIG. 9 as an example.

The first charging-discharging circuit 21 includes a capacitor-array circuit C1, a power supply V1, a first electronic switch M1, a first resistor R1, and a second electronic switch M2; the second charging-discharging circuit 22 includes a capacitor-array circuit C2, a power supply V1, a first electronic switch M3, a first resistor R2, and a second electronic switch M4. The first electronic switch is a PMOS transistor, and the second electronic switch is an NMOS transistor. A first input terminal and a second input terminal of the first comparator 11 correspond to a non-inverting input terminal and an inverting input terminal of the first comparator, respectively. A first input terminal and a second input terminal second comparator 12 correspond to a non-inverting input terminal and an inverting input terminal of the second comparator, respectively. The logical unit is an RS trigger 13, and the RS trigger 13 includes an input terminal S, an input terminal R, an output terminal Q, and an output terminal Qn. The output terminal Q and the output terminal Qn of the RS trigger 13 output clock signals CLK and CLKn respectively.

In the first half clock cycle of the RC oscillator circuit, previous states of Q and Qn are a high level and a low level respectively, the first electronic switch M1 is turned on, the second electronic switch M2 is turned off, the first charging-discharging circuit 21 performs charging, and the first comparator I1 outputs a high level to the input terminal R of the RS trigger 13; meanwhile, the first electronic switch M3 is turned off, the second electronic switch M4 is turned on, the second charging-discharging circuit 22 performs discharging, the second comparator 12 outputs a low level to the input terminal S of the RS trigger 13, the output terminal Q of the RS trigger 13 switches to a low level, the output terminal Qn switches to a high level, and the RC oscillator circuit enters the second half clock cycle. In the second half clock cycle, previous states of Q and Qn are a low level and a high level respectively, the first electronic switch M1 is turned off, the second electronic switch M2 is turned on, the first charging-discharging circuit 21 performs discharging, and the first comparator 11 outputs a low level to the input terminal R of the RS trigger 13; meanwhile, the first electronic switch M3 is turned on, the second electronic switch M4 is turned off, the second charging-discharging circuit 22 performs charging, the second comparator 12 outputs a high level to the input terminal S of the RS trigger 13, the output terminal Q of the RS trigger 13 switches to a high level, and the output terminal Qn switches to a low level. In this way, the RC oscillator circuit finishes charging and discharging of a whole clock cycle.

The technical characteristics of the above embodiments can be employed in arbitrary combinations. In an effort to provide a concise description of these embodiments, not all possible combinations of all technical characteristics of the embodiments are described; however, these combinations of technical characteristics should be construed as disclosed in the description as long as no contradiction occurs.

The above-mentioned examples only express several implementations of the present disclosure, and the descriptions thereof are relatively specific and detailed, but they should not be thereby interpreted as limiting the scope of the present disclosure. It should be pointed out that several modifications and improvements can also be made by those of ordinary skill in the art without departing from the concept of the present disclosure, and all of these fall within the protection scope of the present disclosure. Therefore, the protection scope of the present disclosure should be subject to the appended claims.

**Claims**

1. A capacitor-array circuit, comprising:

N capacitors; and
N MOS transistors corresponding to the N capacitors in a one-to-one manner, wherein each of the N MOS transistors comprises a drain connected to a terminal of a corresponding capacitor of the N capacitors through at least one metal wire, a source connected to ground, and a gate configured to receive a control signal to control turn-on and turn-off of the MOS transistor;
wherein another terminal of each of the N capacitors is connected to a common terminal, and the common terminal is used as a capacitance output terminal;
a capacitance value of the (n-1)-th capacitor in the N capacitors is $C_{n-1}$, and a capacitance value of the n-th capacitor in the N capacitors is $C_n$, where $C_n=aC_{n-1}$;
an on-resistance of the (n-1)-th MOS transistor in the N MOS transistors is $R_{onn-1}$, and an on-resistance of the n-th MOS transistor in the N MOS transistors is $R_{onn}$;
a resistance of the at least one metal wire between the (n-1)-th capacitor and the (n-1)-th MOS transistor is $R_{netn-1}$, and a resistance of the at least one metal wire between the n-th capacitor and the n-th MOS transistor is $R_{netn}$; and

a sum of $R_{netn-1}$ and $R_{onn-1}$ is greater than or equal to $a$ times a sum of $R_{netn}$ and Ronn, a is greater than 1, N is an integer greater than or equal to 2, and n=[2, N].

2. The capacitor-array circuit according to claim 1, wherein a width-to-length ratio of the (n-1)-th MOS transistor is Mn-1, a width-to-length ratio of the n-th MOS transistor is Mn, the width-to-length ratio Mn of the n-th MOS transistor is b times the width-to-length ratio Mn-1 of the (n-1)-th MOS transistor, where b=a, the resistance $R_{netn-1}$ of the at least one metal wire between the (n-1)-th capacitor and the (n-1)-th MOS transistor is greater than or equal to $a$ times the resistance $R_{netn}$ of the at least one metal wire between the n-th capacitor and the n-th MOS transistor.

3. The capacitor-array circuit according to claim 2, wherein a=b=2, the resistance $R_{netn-1}$ of the at least one metal wire between the (n-1)-th capacitor and the (n-1)-th MOS transistor is greater than or equal to 2 times the resistance $R_{netn}$ of the at least one metal wire between the n-th capacitor and the n-th MOS transistor.

4. The capacitor-array circuit according to claim 1, wherein the at least one metal wire between the n-th capacitor and the n-th MOS transistor comprises $a^{n-1}$ metal wires, where $a$ is an integer greater than 1; and wherein each of the at least one metal wire has a same resistance value, and the at least one metal wire is connected in parallel between each capacitor and a corresponding MOS transistor.

5. The capacitor-array circuit according to claim 1, wherein the at least one metal wire connected between the (n-1)-th capacitor and the (n-1)-th MOS transistor comprises one metal wire and a resistance of the one metal wire is $R_{netn-1}$; the at least one metal wire connected between the n-th capacitor and the n-th MOS transistor comprises one metal wire and a resistance of the one metal wire is $R_{netn}$; and the resistance $R_{netn-1}$ of the one metal wire between the (n-1)-th capacitor and the (n-1)-th MOS transistor is $a$ times the resistance $R_{netn}$ of the one metal wire between the n-th capacitor and the n-th MOS transistor.

6. The capacitor-array circuit according to claim 1, wherein each of the at least one metal wire connected between each capacitor and a corresponding MOS transistor has a same resistance per square, and the number of squares of the at least one metal wire connected between the (n-1)-th capacitor and the (n-1)-th MOS transistor is $a$ times the number of the square of the at least one metal wire connected between the n-th capacitor and the n-th MOS transistor.

7. The capacitor-array circuit according to claim 1, wherein the number of the at least one metal wire connected in series between the (n-1)-th capacitor and the (n-1)-th MOS transistor is $a$ times the number of the at least one metal wire connected in series between the n-th capacitor and the n-th MOS transistor, each of the at least one metal wire connected between each capacitor and a corresponding MOS transistor has a same resistance per square, and a resistance per square of the at least one metal wire connected in series between the (n-1)-th capacitor and the (n-1)-th MOS transistor is the same as a resistance per square of the at least one metal wire connected in series between the n-th capacitor and the n-th MOS transistor.

8. The capacitor-array circuit according to claim 1, wherein the number of the at least one metal wire connected in parallel between the n-th capacitor and the n-th MOS transistor is $a$ times the number of the at least one metal wire connected in parallel between the (n-1)-th capacitor and the (n-1)-th MOS transistor, each of the at least one metal wire connected between each capacitor and a corresponding MOS transistor has a same resistance per square, and a resistance per square of the at least one metal wire connected in series between the (n-1)-th capacitor and the (n-1)-th MOS transistor is the same as a resistance per square of the at least one metal wire connected in series between the n-th capacitor and the n-th MOS transistor.

9. The capacitor-array circuit according to claim 1, wherein the at least one metal wire is at least one copper wire.

10. The capacitor-array circuit according to claim 1, wherein the control signal is a pulse signal.

11. A capacitor charging-discharging circuit, comprising the capacitor-array circuit according to any one of claims 1 to 10, a power supply, a first electronic switch, a first resistor, and a second electronic switch, wherein a first terminal of the first electronic switch is connected to the power supply; a second terminal of the first electronic switch is connected, through the resistor, to both the capacitance output terminal and a first terminal of the second electronic switch; a second terminal of the second electronic switch is connected to ground; each of a control terminal of the first electronic switch and a control terminal of the second electronic switch is configured to receive a clock signal; and each of the first electronic switch and the second electronic switch is turned on and turned off based on the clock signal.

**12.** The capacitor charging-discharging circuit according to claim 11, wherein the first electronic switch is a PMOS transistor, and the second electronic switch is an NMOS transistor.

**13.** An RC oscillator circuit, comprising a first charging-discharging circuit, a second charging-discharging circuit, a first comparator, a second comparator, a reference voltage unit, a logical unit, and a control unit, wherein each of the first charging-discharging circuit and the second charging-discharging circuit is the capacitor charging-discharging circuit according to claim 7 or 8; a first input terminal of the first comparator is connected to a capacitance output terminal of the first charging-discharging circuit, and a second input terminal of the first comparator is connected to the reference voltage unit; a first input terminal of the second comparator is connected to a capacitance output terminal of the second charging-discharging circuit, and a second input terminal of the second comparator is connected to the reference voltage unit; an output terminal of the first comparator and an output terminal of the second comparator are both connected to an input terminal of the logical unit, and an output terminal of the logical unit is respectively connected to a control end of a first electronic switch and a control end of a second electronic switch; and the control unit is connected to a gate of each MOS transistor;

the reference voltage unit is configured to generate a reference voltage;
the first charging-discharging circuit is configured to transmit a first charging voltage or a first discharging voltage to the first comparator;
the first comparator is configured to compare the first charging voltage with the reference voltage, or compare the first discharging voltage with the reference voltage, and output a first comparison result to the logical unit;
the second charging-discharging circuit is configured to transmit a second charging voltage or a second discharging voltage to the second comparator;
the second comparator is configured to compare the second charging voltage with the reference voltage, or compare the second discharging voltage with the reference voltage, and output a second comparison result to the logical unit;
the logical unit is configured to output a clock signal based on the first comparison result and the second comparison result;
the first charging-discharging circuit and the second charging-discharging circuit are configured to perform charging and discharging based on the clock signal; and
the control unit is configured to control turn-on and turn-off of each MOS transistor through a control signal, to regulate a total capacitance of a capacitor-array circuit.

**14.** The RC oscillator circuit according to claim 13, wherein the logical unit comprises an RS trigger.

FIG. 1

FIG. 2

FIG. 3

FIG. 4

FIG. 5

FIG. 6

Capacitor — $2^{n-1}$ metal wires · · · — MOS transistor

Capacitor — $2^{n-2}$ metal wires · · · — MOS transistor

•
•
•

Capacitor — 1 metal wire — MOS transistor

FIG. 7

Capacitor — 1 metal wire — MOS transistor

Capacitor — 2 metal wires — MOS transistor

Capacitor — 4 metal wires — MOS transistor

•
•
•

Capacitor — $2^{n}$ metal wires — MOS transistor

FIG. 8

FIG. 9

## INTERNATIONAL SEARCH REPORT

| International application No. |
|---|
| **PCT/CN2020/113056** |

**A.    CLASSIFICATION OF SUBJECT MATTER**

H03B 5/12(2006.01)i

According to International Patent Classification (IPC) or to both national classification and IPC

**B.    FIELDS SEARCHED**

Minimum documentation searched (classification system followed by classification symbols)

H03B5/-

Documentation searched other than minimum documentation to the extent that such documents are included in the fields searched

Electronic data base consulted during the international search (name of data base and, where practicable, search terms used)

CNABS; CNTXT; VEN; USTXT; EPTXT; WOTXT; CNKI: 电容, 阵列, 开通电阻, 振荡器, 时钟, 频率, 精度, 充电, 放电, 调节, 改变, capacitor, arrays, on-resistance, oscillator, clock, frequency, accuracy, charge, discharge, adjust, change

**C.    DOCUMENTS CONSIDERED TO BE RELEVANT**

| Category* | Citation of document, with indication, where appropriate, of the relevant passages | Relevant to claim No. |
|---|---|---|
| A | CN 103873048 A (WUXI ZHONGKE MICROELECTRONIC INDUSTRIAL TECHNOLOGY RESEARCH INSTITUTE CO., LTD.) 18 June 2014 (2014-06-18) description paragraphs 29-31, 41-82, figures 1-5 | 1-14 |
| A | CN 109525197 A (NO.47 INSTITUTE OF CHINA ELECTRONICS TECHNOLOGY GROUP CORPORATION) 26 March 2019 (2019-03-26) description, paragraphs 36-50, and figures 2-4 | 1-14 |
| A | CN 110995161 A (ANHUI UNIVERSITY) 10 April 2020 (2020-04-10) entire document | 1-14 |
| A | US 2007285185 A1 (SAMSUNG ELECTRO-MECHANIC CO., LTD.) 13 December 2007 (2007-12-13) entire document | 1-14 |
| A | CN 106796259 A (SHENZHEN GOODIX TECHNOLOGY CO., LTD.) 31 May 2017 (2017-05-31) entire document | 1-14 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 May 2021** | **02 June 2021** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088** <br> **China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/113056**

| Patent document cited in search report | | | Publication date (day/month/year) | Patent family member(s) | | | Publication date (day/month/year) |
|---|---|---|---|---|---|---|---|
| CN | 103873048 | A | 18 June 2014 | CN | 103873048 | B | 01 February 2017 |
| CN | 109525197 | A | 26 March 2019 | None | | | |
| CN | 110995161 | A | 10 April 2020 | None | | | |
| US | 2007285185 | A1 | 13 December 2007 | KR | 100744912 | B1 | 01 August 2007 |
| | | | | US | 7498884 | B2 | 03 March 2009 |
| | | | | JP | 2007318760 | A | 06 December 2007 |
| | | | | JP | 4460588 | B2 | 12 May 2010 |
| CN | 106796259 | A | 31 May 2017 | WO | 2018085972 | A1 | 17 May 2018 |
| | | | | CN | 106796259 | B | 15 October 2019 |

Form PCT/ISA/210 (patent family annex) (January 2015)